# EUROPÄISCHE PATENTSCHRIFT

(11) **EP 3 319 738 B1**
(45) Veröffentlichungstag und Bekanntmachung des Hinweises auf die Patenterteilung: **28.08.2019**
(21) Anmeldenummer: 16723061.4
(22) Anmeldetag: 09.05.2016
(51) Int. Cl.: B06B 1/06, G10K 9/12, G10K 9/122, G10K 9/125, H04R 17/00, H04R 17/02

(54) **SCHALLWANDLER**
SOUND TRANSDUCER
TRANSDUCTEUR ACOUSTIQUE

(30) Priorität: 07.07.2015 DE 102015212686
(43) Veröffentlichungstag der Anmeldung: 16.05.2018
(73) Patentinhaber: Robert Bosch GmbH, 70442 Stuttgart (DE)
(72) Erfinder: KARL, Matthias, 76275 Ettlingen (DE)
(86) Internationale Anmeldenummer: PCT/EP2016/060342
(87) Internationale Veröffentlichungsnummer: WO 2017/005395

(56) Entgegenhaltungen:
- DE-B3- 10 361 393
- US-A- 4 420 826
- US-A- 4 862 429
- US-A- 4 932 008
- US-A1- 2015 187 349

## Beschreibung

### Stand der Technik

Die Erfindung betrifft einen Schallwandler nach dem Oberbegriff des Anspruchs 1.

Ein Schallwandler nach dem Oberbegriff des Anspruchs 1 ist aus der DE 10 2012 201 884 A1 der Anmelderin bekannt. Derartige Schallwandler kommen beispielsweise bei Ultraschallsensoren zum Einsatz, mit denen sich der Abstand zwischen dem Ultraschallsensor und einem reflektierenden Objekt messen lässt. Der Schallwandler dient dabei als Sender und/oder Empfänger, wobei in einem ersten Schritt ein Ultraschallimpuls abgestrahlt wird. Trifft der Ultraschallpuls auf ein reflektierendes Objekt, wird ein Ultraschallecho erzeugt, welches über den Schallwandler wieder detektiert werden kann. Aus der Zeit, die zwischen Aussenden des Ultraschallpulses und detektieren des Ultraschallechos vergangen ist sowie der bekannten Schallgeschwindigkeit kann auf die Entfernung zum reflektierenden Objekt geschlossen werden. Derartige Schallwandler werden insbesondere als Bestandteil von Fahrassistenzsystemen zur Unterstützung des Fahrers eines Fahrzeugs bei Fahrmanövern eingesetzt. Beispielsweise sind mehrere Ultraschallwandler im Bereich eines Stoßfängers des Fahrzeugs nebeneiander in bestimmten Abständen zueinander eingebaut. Derartige Ultraschallsensoren bzw. Schallwandler müssen hohen Anforderungen an die mechanische Stabilität genügen. Insbesondere bei Schallwandlern, die in der Front eines Fahrzeugs angeordnet sind, können durch fliegende Steinchen oder andere Partikel die Schallwandler im Bereich deren Membran stark beansprucht werden. Dabei dürfen die darin enthaltenen Piezoaktoren bzw. Piezoelemente, die im Wesentlichen aus einer Keramik bestehen, nicht beschädigt werden. Ein Zerbrechen des Piezoelements würde zum Totalausfall des Schallwandlers führen. Insbesondere aus den zuletzt genannten Gründen ist es aus der eingangs erwähnten Schrift bekannt, das Piezoelement bzw. den Piezoaktor nicht unmittelbar (vollflächig) mit der Membran zu verbinden, sondern den Piezoaktor parallel und mit Abstand zur Membran anzuordnen und über wenigstens ein Hebelelement mit der Membran zu verbinden. Dabei ist es in der vorbekannten Schrift insbesondere vorgesehen, das wenigstens eine Hebelelement auf der dem Piezoaktor zugewandten Seite im Bereich der Stirnfläche des Piezoaktors mit dem Piezoaktor zu verkleben. Bei einem Schwingen des Piezoaktors in einer parallel zur Ebene der Membran angeordneten Schwingungsebene wird über das wenigstens eine Hebelelement die Membran ebenfalls in Schwingungen versetzt, wobei die Schwingungsebene der Membran senkrecht zur Schwingungsebene des Piezoaktors verläuft. Weiterhin ist es aus der genannten Schrift entnehmbar, dass durch die Länge des wenigstens einen Hebelelements das Verhältnis von Kraft und Auslenkung der Membran ausgelegt werden kann. Insbesondere lassen sich somit unterschiedliche Übersetzungsverhältnisse der Schwingungsamplituden zischen dem Piezoaktor und der Membran erzielen. Auch ist es erwähnt, dass anstelle der in der Schrift offenbarten und gezeigten Klebeverbindungen auch Klemmverbindungen im Randbereich des Piezoelements bzw. Piezoaktors vorgesehen werden können. Nähere Angaben, wie eine derartige Klemmverbindung ausgebildet sein kann, sind der genannten Schrift jedoch nicht entnehmbar.

Das Dokument US 2015/0187349 A) beschreibt einen Schallwandler mit einem Piezoaktor als Wandlerelement. Der Piezoaktor ist zwischen zwei Membranen eingeklemmt. Zusätzlich ist an den Stirnseiten des Piezoaktors ein Ring angeordnet, welcher den Piezoaktor unter eine in Schwingungsrichtung des Piezoaktors verlaufenden, axialen Vorspannkraft anordnet.

Das Dokument US 4 420 826 A beschreibt einen Schallwandler, dessen Piezoaktor zwischen zwei Membranen angeordnet ist und auf beiden Seite über Hebelelemente in Wirkanordnung mit den Membranen steht. Die beiden Hebelelemente klemmen den Piezoaktor ein und führen dazu, dass dieser mit einer in Schwingungsrichtung des Piezoaktors verlaufenden, axialen Vorspannkraft angeordnet ist. Damit bei Anwendungen unter hohem Druck der Piezoaktor nicht durch zu viel Längsbelastung zerreißt, ist wenigstens eine Seite des Piezoaktors lose mit dem Hebelelement verbunden. Der Piezoaktor wird über Schienen geführt, damit in Situationen mit hohem Druck der Piezoaktor trotzdem zwischen den beiden Membranen verbleibt. Damit der Piezoaktor bei anschließendem Druckverlust wieder in die ursprüngliche Position gleitet, kann zwischen Schienen und Piezoaktor eine konische Verbindung bestehen.

Das Dokument US 4 862 429 A beschreibt ebenfalls einen flexiblen elektroakustischen Schallwandler, dessen Piezoaktor in einem Art Gehäuse zwischen zwei Membranen angeordnet ist und über gelenkig miteinander verbundene Hebelarme in Wirkanordnung mit den Membranen steht.

Das Dokument US 4 932 008 A beschreibt einen flexiblen elektroakustischen Schallwandler. Hierbei sind die beiden Membranen über ein Drehgelenk mit dem jeweiligen Hebel verbunden.

### Offenbarung der Erfindung

Ausgehend von dem dargestellten Stand der Technik liegt der Erfindung die Aufgabe zugrunde, einen Schallwandler nach dem Oberbegriff des Anspruchs 1 derart weiterzubilden, dass eine konstruktiv vorteilhafte Verbindung zwischen dem Piezoaktor und dem wenigstens einen Hebelelement ausgebildet wird.

Diese Aufgabe wird erfindungsgemäß bei einem Schallwandler mit den Merkmalen des Anspruchs 1 dadurch gelöst, dass die Klemmverbindung im Bereich zwischen einer in Schwingungsrichtung des Piezoaktors angeordneten Stirnseite des Piezoaktors und dem wenigstens einen Hebelelement ausgebildet ist, und dass der Piezoaktor durch das wenigstens eine Hebelelement unter axialer Vorspannkraft angeordnet ist.

Eine derartige Anordnung ermöglicht es insbesondere, den üblicherweise im Bereich des Piezoaktors zur Verfügung stehenden radialen Bauraum für die Ausbildung der Klemmverbindung auszunutzen und somit beispielsweise den Abstand zwischen dem Piezoaktor und der Membran zu verringern, was die Bauhöhe des Schallwandlers verringert. Darüber hinaus wird es durch die Aufbringung der axialen Vorspannkraft durch das wenigstens eine Hebelelement auf den Piezoaktor ermöglicht, die Piezokeramik des Piezoaktors mit einer mechanischen Vorspannung einzuspannen. Die damit verbundene Ladungsverschiebung definiert einen Arbeitspunkt, wobei die mechanische Vorspannung den Wirkungsgrad des Piezoaktors verbessern kann.

Vorteilhafte Weiterbildungen des erfindungsgemäßen Schallwandlers sind in den Unteransprüchen aufgeführt.

In konstruktiver Ausgestaltung der Klemmverbindung, die nicht zur Erfindung gehört, ist diese als formschlüssige Verbindung ausgebildet, bei der das wenigstens eine Hebelelement oder der Piezoaktor eine Aufnahme zur formschlüssigen Aufnahme des Piezoaktors im Bereich dessen Stirnseite aufweist. Eine derartige Ausbildung ermöglicht insbesondere einen besonders sicheren Halt bzw. eine besonders sichere Klemmverbindung während des Schwingens des Piezoaktors und somit eine besonders zuverlässige Verbindung zwischen dem wenigstens einen Hebelelement und dem Piezoaktor.

Bei der konstruktiven Ausgestaltung der Klemmverbindung ist es vorgesehen, dass die Klemmverbindung eine konkav ausgebildete Kontaktfläche zwischen dem Piezoaktor und dem wenigstens einen Hebelelement zur Ausbildung einer selbstzentrierenden Klemmverbindung umfasst. Dadurch führt ein Verrutschen des Piezoaktors relativ zum wenigstens einen Hebelelement zu einer höheren mechanischen Klemmspannung, die letztendlich ein Zurückrutschen in die spezifizierte Klemmposition begünstigt, bei der die Klemmung unter minimaler mechanischer Spannung stattfindet.

Um einen mechanisch besonders robusten Piezoaktor bei gleichzeitig genügend großem Hub zur Erzeugung der Schwingungen auszubilden, kann es darüber hinaus vorgesehen sein, dass der Piezoaktor als gestapelter Piezoaktor mit mehreren in Richtung der Schwingungsebene des Piezoaktors wirkenden Piezoelementen ausgebildet ist, deren Schwingungsamplituden sich in der Schwingungsebene des Piezoaktors addieren.

In fertigungstechnisch bevorzugter Ausgestaltung des wenigstens einen Hebelelements ist dieses einstückig an der Membran angeordnet bzw. ausgebildet.

In einer weiteren konstruktiven Ausgestaltung, die nicht zur Erfindung gehört, kann es auch vorgesehen sein, dass zwei in einer Achse gelenkig miteinander verbundene Hebelelemente vorgesehen sind, und dass die Achse vorzugsweise fluchtend zu einer senkrecht zur Schwingungsebene des Piezoaktors angeordneten Mittelebene des Piezoaktors angeordnet ist.

Um einen möglichst einfachen Montageprozess eines derartigen Schallwandlers zu ermöglichen und darüber hinaus ggf. unterschiedliche Materialien für die Membran und das wenigstens eine Hebelelement sowie eine Geometrie des wenigstens einen Hebelelements, die sich nicht einstückig aus der Membran fertigen lässt verwenden zu können, ist es in Weiterbildung des zuletzt gemachten Vorschlags bevorzugt vorgesehen, dass die beiden Hebelelemente mittels einer Klemm- oder Rastverbindung mit Fortsätzen der Membran verbunden sind. Die Fortsätze können beispielsweise einstückig an der Membran angeformt sein und auch eine relativ geringe Länge aufweisen, so dass sie sich relativ einfach herstellen lassen.

Zur Verbesserung der Funktionalität des Schallwandlers bzw. der Vermeidung der Abstrahlung von Schwingungen in nicht gewünschte Richtungen ist es darüber hinaus vorgesehen, dass die Membran bzw. der Schallwandler mit Mitteln zur Dämpfung und/oder Entkopplung von Schwingungen in einer senkrecht zur Schwingungsebene der Membran angeordneten Richtung ausgestattet ist. Derartige Mittel können beispielsweise durch die Ausbildung einer vorzugsweise radial umlaufenden Sicke im Bereich der Membran ausgebildet werden, wobei im Bereich der Sicke die Materialdicke der Membran reduziert ist. Alternativ kann jedoch auch in dem genannten Bereich anstelle einer Sicke eine Erhöhung der Dicke der Membran vorgesehen sein. Darüber hinaus kann auch ein von der Membran separates Dämpfungselement in Form eines Schaums oder ähnliches im Innenraum des Schallwandlers vorgesehen sein, um eine Abstrahlung von Schallwellen in nicht gewünschte Richtungen zu vermeiden bzw. zu reduzieren.

Als Material für die Membran kommen Metalle, vorzugsweise Aluminium, sowie keramische Werkstoffe oder ein Verbundwerkstoff in Frage. Insbesondere bei einstückig an der Membran angeordneten Hebelelementen kann es ggf. (abhängig von der Geometrie des Hebelelements) besonders vorteilhaft sein, eine derartige Membran aus einem Verbundwerkstoff auszubilden, da sich damit üblicherweise auch relativ komplexe geometrische Formen herstellen lassen.

Beim Stand der Technik bzw. bei üblichen Ultraschallwandlern sind die Piezoaktoren über Draht- oder Bondverbindungen mit einem Schaltungsträger, üblicherweise in Form einer Leiterplatte oder ähnlichem verbunden, wobei die Membran ein von dem Schaltungsträger separates Bauteil darstellt.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen vereinfachten Längsschnitt durch einen ersten Schallwandler im Bereich des Piezoaktors mit einer in Form einer formschlüssigen Aufnahme ausgebildeten Klemmverbindung,
- Fig. 2: einen gegenüber Fig. 1 abgewandelten Schallwandler mit einer selbstzentrierenden Klemmverbindung, ebenfalls im Längsschnitt,
- Fig. 3: ein gegenüber Fig. 1 modifiziertes Beispiel mit an der Membran angeordneten Dämpfungselementen im Längsschnitt,
- Fig. 4: einen vereinfachten Schnitt durch einen aus mehreren Piezoelementen bestehenden Piezoaktor, wie er alternativ bei den Schallwandlern eingesetzt werden kann,
- Fig. 5: ein Längsschnitt durch einen nochmals modifizierten Schallwandler unter Verwendung zweier gelenkig miteinander verbundener Hebelelemente,
- Fig. 6: einen Längsschnitt durch ein gegenüber Fig. 5 abgewandeltes Beispiel, bei der die Hebelelemente über eine Rastverbindung mit der Membran verbunden sind,
- Fig. 7: ein Längsschnitt durch einen weiteren Schallwandler im Bereich des Piezoaktors,
- Fig. 8: eine Draufsicht in Richtung des Pfeils IX der Fig. 7 und
- Fig. 9: einen Schnitt in der Ebene IX-IX der Fig. 8.

Gleiche Elemente bzw. Elemente mit gleicher Funktion sind in den Figuren mit den gleichen Bezugsziffern versehen.

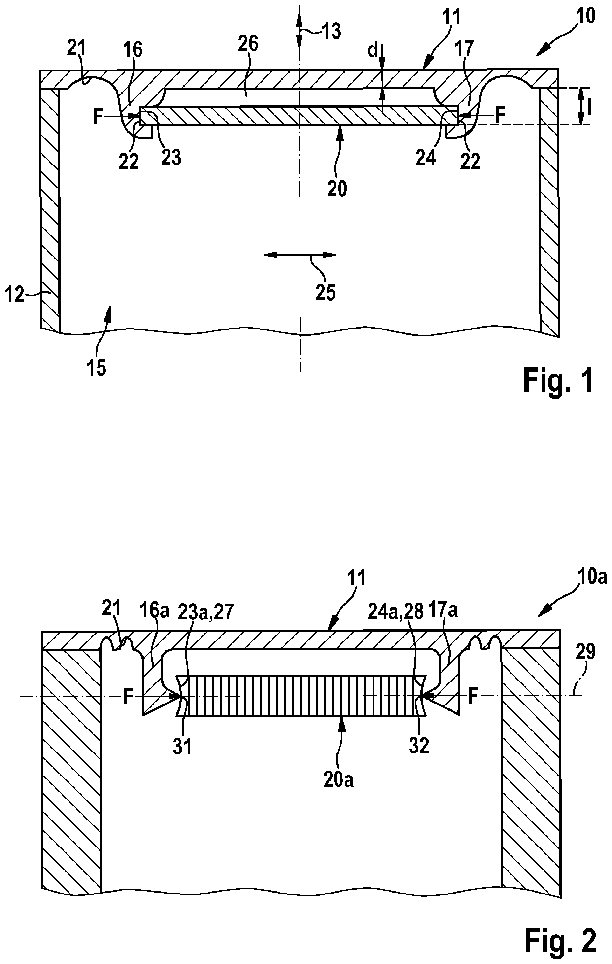

In der Fig. 1 ist ein Teilbereich eines Schallwandlers 10 dargestellt, wie er insbesondere als Bestandteil eines Fahrerassistenzsystems zur Erfassung von Abständen zwischen dem Schallwandler 10 bzw. einem nicht dargestellten Fahrzeug und Objekten dient. Insbesondere können mehrere derartige Schallwandler 10 in bestimmten seitlichen Abständen zueinander versetzt im Bereich eines Stoßfängers im Heckbereich oder im Frontbereich des Fahrzeugs vorgesehen sein.

Der Schallwandler 10 weist eine beispielhaft aus Metall, insbesondere aus Aluminium, alternativ aus einem Verbundwerkstoff oder aus Keramik bestehende Membran 11 auf. Die Membran 11 bildet eine Stirnseite eines lediglich bereichsweise dargestellten Gehäuses 12 des Schallwandlers 10 aus und kann beispielsweise durch nicht dargestellte Entkopplungsmittel von dem Gehäuse 12 entkoppelt sein. Das Gehäuse 12 ist wiederum in bekannter Art und Weise in eine nicht gezeigte Aussparung eines Stoßfängers des Fahrzeugs eingesetzt und verläuft vorzugsweise flächenbündig mit dem Stoßfänger.

Die Membran 11 weist insbesondere einen runden Querschnitt auf und ist in Richtung des Doppelpfeils 13, welche die Richtung der Schwingungsebene der Membran 11 darstellt, schwingungsfähig ausgebildet. Auf der einem Innenraum 15 des Gehäuses 12 zugewandten Seite sind an der Membran 11 zwei Hebelelemente 16, 17 einstückig angeformt, die der Befestigung eines scheibenförmigen Piezoaktors 20, welcher eine Piezokeramik aufweist, dient. Insbesondere weist die Membran 11 im Bereich zwischen den beiden identisch ausgebildeten Hebelelementen 16, 17 eine konstante Dicke d auf. In einem radial außerhalb der beiden Hebelelemente 16, 17 angeordneten Bereich ist die Dicke d der Membran 11 durch eine radial umlaufende Sicke 21 reduziert.

Die beiden Hebelelemente 16, 17 weisen eine im Querschnitt jeweils in etwa U-förmige Aufnahme 22 auf, die dazu ausgebildet ist, den Piezoaktor 20 im Bereich der beiden gegenüberliegenden Stirnseiten 23, 24 zu umfassen. Dadurch wird zwischen den beiden Hebelelementen 16, 17 und dem Piezoaktor 22 eine formschlüssige Klemmverbindung ausgebildet, die auch ohne die Verwendung von Klebstoff ein sicheres Halten und Positionieren des Piezoaktors 20 relativ zur Membran 11 ermöglicht. Der Piezoaktor 20 weist eine Schwingungsebene auf, die in Richtung des Doppelpfeils 25 verläuft, wobei die beiden Doppelpfeile 13, 25 bzw. die Schwingungsebene der Membran 11 und des Piezoaktors 20 zumindest im Wesentlichen senkrecht zueinander angeordnet sind, und wobei die beiden Stirnseiten 23, 24 senkrecht zum Doppelpfeil 25 angeordnet sind. Zwischen dem Piezoaktor 20 und der Membran 11, die somit vorzugsweise parallel zueinander angeordnet sind, ist ein Freiraum 26 ausgebildet, der eine Schwingung bzw. Deformation der Membran 11 ermöglicht. Die beiden Hebelelemente 16, 17 weisen jeweils in Bezug zu einer senkrecht zur Ebene der Membran 11 verlaufenden Richtung zwischen der Aufnahme 22 und der Membran 11 eine Hebellänge I auf und sind darüber hinaus im Wesentlichen starr ausgebildet.

In der Fig. 1 ist der Zustand dargestellt, bei der der Schallwandler 10 bzw. der Piezoaktor 20 (und somit auch die Membran 11) nicht zu Schwingungen angeregt ist. Bei einer Schwingung des Piezoaktors 20 in Richtung des Doppelpfeils 25 werden die Schwingungen des Piezoaktor 10 über die beiden Hebelelemente 16, 17 auf die Membran 11 übertragen bzw. in diese eingeleitet, was wiederum in einer Schwingung der Membran 11 in Richtung des Doppelpfeils 13 resultiert. Wesentlich ist auch, dass die Anordnung bzw. geometrische Ausbildung der Hebelelemente 16, 17 derart ist, dass über die Hebelelemente 16, 17 im Bereich der beiden Stirnseiten 23, 24 des Piezoaktors 20 jeweils eine in der Ebene des Piezoaktors 20 verlaufende axiale Vorspannkraft F eingeleitet wird, der Piezoaktor 20 somit in axialer Richtung "vorgespannt" ist.

Der in der Fig. 2 dargestellte Schallwandler 10a unterscheidet sich von dem Schallwandler 10 dadurch, dass der Piezoaktor 20a im Bereich der beiden Stirnflächen 23a, 24a mit jeweils einer erfindungsgemäßen, konkav ausgebildeten Kontaktfläche 27, 28 ausgestattet ist, wobei die beiden Kontaktflächen 27, 28 symmetrisch zu einer Mittelebene 29 des Piezoaktors 20a verlaufen, in der auch ein linienförmiger Kontakt zwischen Anlagekanten 31, 32 der Hebelelemente 16a, 17a an dem Piezoaktor 20a erfolgt. Auch bei dem Schallwandler 10a ist es vorgesehen, dass über die Hebelelemente 16, 17 im Bereich der beiden Stirnseiten 23, 24 des Piezoaktors 20a jeweils eine axiale Vorspannkraft F auf den Piezoaktor 20a eingeleitet wird.

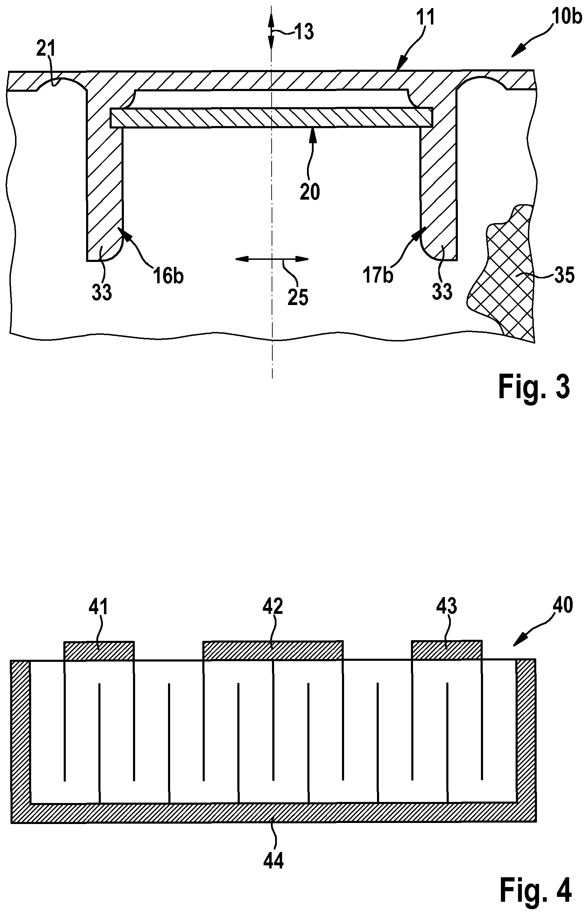

Der in der Fig. 3 dargestellte Schallwandler 10b unterscheidet sich von dem Schallwandler 10 gemäß der Fig. 1 im Wesentlichen dadurch, dass die beiden Hebelelemente 16b, 17b auf der der Membran 11 abgewandten Seite mit jeweils einer Verlängerung 33 ausgebildet sind. Aufgrund der geometrischen Ausgestaltung bzw. Masse der Verlängerungen 33 werden von der Membran 11 bzw. dem Schallwandler 10b abgestrahlte Signale in einer quer zur Richtung des Doppelpfeils 13 verlaufenden Richtung geschwächt bzw. gedämpft. Außerdem bzw. ergänzend kann es vorgesehen sein, dass die Verlängerungen 33 eine Resonanzfrequenz aufweisen, die sich deutlich von der Frequenz unterscheidet, mit der die Membran 11 angesteuert wird, welche vorzugsweise die Resonanzfrequenz der Membran 11 ist. Somit verhindern die unterschiedlichen Schwingungseigenschaften der Membran 11 und der Hebelelemente 16b, 17b einen sogenannten akustischen Kurzschluss zwischen benachbarten Schallwandlern. Alternativ bzw. zusätzlich kann es auch vorgesehen sein, dass beispielsweise im Bereich des Innenraums 15 des Gehäuses 12 eine Dämpfungsmasse 35, wie an sich aus dem Stand der Technik bekannt und daher lediglich bereichsweise dargestellt, angeordnet ist.

Bei den soweit beschriebenen Piezoaktoren 20, 20a weisen diese eine relativ geringe Dicke auf, da die wirksamen Piezoschichten parallel zur Ebene des Piezoaktors 20, 20a angeordnet sind. Anstelle eines derartigen Piezoaktors 20, 20a kann alternativ auch ein Piezoaktor 40 entsprechend der Darstellung der Fig. 4 verwendet werden. Der Piezoaktor 40 ist als sogenannter gestapelter Piezoaktor 40 ausgebildet, bei denen mehrere Piezoelemente 41 bis 44 mit jeweils einer Vielzahl von Piezokeramikschichten derart miteinander verbunden sind, dass sich deren Ausdehnungen aufsummieren.

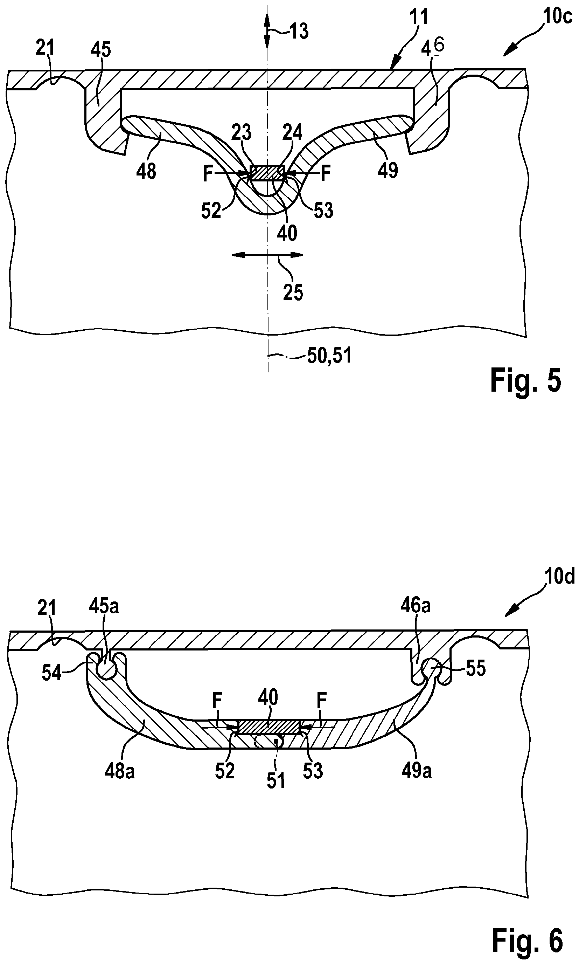

In der Fig. 5 ist bereichsweise ein Schallwandler 10c dargestellt, bei dem an dessen Membran 11 lediglich relativ kurze Fortsätze 45, 46 angeordnet bzw. angeformt sind. In die beiden Fortsätze 45, 46 greift jeweils der Endbereich eines Hebelelements 48, 49 ein, die im Bereich einer senkrecht zur Schwingungsebene des Piezoaktors 40 angeordneten Mittelebene 50 mittels einer Achse 51 gelenkig miteinander verbunden sind. Auf der den Stirnseiten 23, 24 des Piezoaktors 40 zugewandten Seiten weisen die beiden Hebelelemente 48, 49 Aufnahmeflächen 52, 53, die eine klemmende Aufnahme des Piezoaktors 40 unter Aufbringung einer axialen Vorspannkraft F auf die Stirnseiten 23, 24 ermöglicht. Bei einer Schwingung des Piezoaktors 40 in Richtung des Doppelpfeils 25 verändert sich der Winkel zwischen den beiden Hebelelementen 48, 49 und somit auch deren gegenseitiger Abstand im Bereich der Fortsätze 45, 46, was zu einer Deformation bzw. Schwingung der Membran 11 in Richtung des Doppelpfeils 13 führt. Dadurch, dass die Hebelelemente 48, 49 als gegenüber der Membran 11 separate Bauteile ausgebildet sind, können die Hebelelemente 48, 49 insbesondere auch aus einem gegenüber der Membran 11 unterschiedlichen Material bestehen.

Bei dem in der Fig. 6 dargestellten Schallwandler 10d sind die Fortsätze 45a, 46a ballig bzw. mit einer Aufnahme ausgebildet, die mit entsprechend geformten Endbereichen 54, 55 der Hebelelemente 48a, 49a derart zusammenwirken, dass die Hebelelemente 48a, 49a im Bereich der Fortsätze 45a, 46a schwenkbar angeordnet sind. Darüber hinaus sind die beiden Hebelelemente 48a, 49a, im Gegensatz zu den Hebelelementen 48, 49 beim Schallwandler 10c zumindest im Bereich des Piezoaktors 40 zumindest im Wesentlichen in einer gemeinsamen Ebene zueinander ausgerichtet.

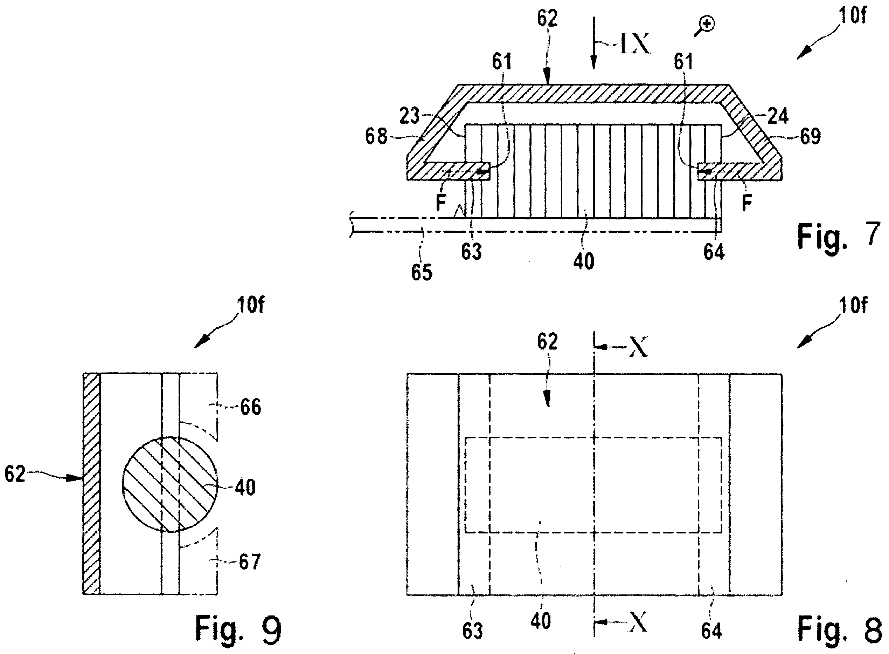

Zuletzt ist in den Fig. 7 bis 9 ein weiterer Schallwandler 10f dargestellt, dessen Piezoaktor 40 im Bereich der beiden Stirnseiten 23, 24 jeweils eine senkrecht zur Ebene der Fig. 7 verlaufende nutartige Aussparung 61 aufweist, in die ein umgebogener Endabschnitt 63, 64 einer Membran 62 eingreift. Dadurch, dass der Abstand der beiden Endabschnitte 63, 64 der Membran 62, die in die Aussparungen 61 eingreifen, im unbelasteten Zustand geringer ist als der Abstand zwischen den beiden Nutgründen der Aussparungen 61, wird über die Membran 62 in Analogie zu dem soweit beschriebenen Schallwandler 10, 10a bis 10e eine axiale Vorspannkraft F auf den Piezoaktor 40 ausgeübt. Die beiden Endabschnitte 63, 64 sind über gegenüber der Ebene der Membran 62 schräg angeordneten Hebelelementen 68, 69 mit der Membran 62 verbunden. Wie bereits angedeutet, kann die Membran 62 zusammen mit den Endabschnitten 63, 64 und den Hebelelementen 68, 69 als einstückiges Bauteil ausgebildet sein. Es ist jedoch auch möglich bzw. sinnvoll, die Hebelelemente 68, 69 zusammen mit den Endabschnitten 63, 64 als von der Membran 62 separate Bauteile auszubilden. Weiterhin kann es optional vorgesehen sein, dass der Piezoaktor 40 auf der der Membran 62 abgewandten Seite mit einer Leiterplatte 65 bzw. einem Schaltungsträger verbunden ist. Zuletzt kann es entsprechend der Darstellung der Fig. 9 vorgesehen sein, dass auf der der Membran 62 abgewandten Seite Reflektorelemente 66, 67 vorgesehen sind, die eine Reflektion von Schallwellen in Richtung der Membran 62 ermöglichen.

## Patentansprüche

1. Schallwandler (10a), umfassend eine Membran (11) und wenigstens einen Piezoaktor (20a; 40) mit zwei gegenüberliegenden, in Schwingungsrichtung (25) des Piezoaktors (20a; 40) angeordneten Stirnseiten (23a, 24a), der mit der Membran (11) in Wirkverbindung angeordnet ist, wobei die Schwingungsrichtung (25) des Piezoaktors (20a; 40) zumindest im Wesentlichen senkrecht zur Schwingungsrichtung (13) der Membran (11) angeordnet ist, wobei der Schallwandler ferner zwei Hebelelemente (16a, 17a) mit Anlagekanten (31,32) umfasst, wobei die Hebelelemente zwischen der Membran (11) und dem Piezoaktor (20a; 40) angeordnet sind, die Membran (11) mit dem Piezoaktor (20a; 40) verbinden und dazu ausgebildet sind, Schwingungen des Piezoaktors (20a; 40) in Schwingungen der Membran (11) umzuwandeln und umgekehrt, und wobei zwischen jeweils einem der beiden Hebelelemente (16a; 17a) und dem Piezoaktor (20a; 40) eine Klemmverbindung ausgebildet ist,
wobei die jeweilige Klemmverbindung im Bereich zwischen jeweils einer der beiden in Schwingungsrichtung (25) des Piezoaktors (20a; 40) angeordneten Stirnseiten (23a, 24a) des Piezoaktors (20a; 40) und dem jeweiligen Hebelelement (16a;17a) ausgebildet ist, und dass der Piezoaktor (20a; 40) durch die zwei Hebelelemente (16a; 17a) unter eine in Schwingungsrichtung (25) des Piezoaktors (20a; 40) verlaufenden, axialen Vorspannkraft (F) angeordnet ist
**dadurch gekennzeichnet, dass**
der Piezoaktor (20a; 40) im Bereich der beiden Stirnseiten (23a, 24a) jeweils mit einer konkav ausgebildeten Kontaktfläche (27, 28) ausgestattet ist, wobei die beiden Kontaktflächen (27, 28) symmetrisch zu einer Mittelebene (29) des Piezoaktors (20a; 40) verlaufen, in der ein linienförmiger Kontakt zwischen den Anlagekanten (31, 32) der Hebelelemente (16a; 17a) an dem Piezoaktor (20a; 40) erfolgt.

2. Schallwandler nach Anspruch 1,
**dadurch gekennzeichnet,**
**dass** der Piezoaktor (40) als gestapelter Piezoaktor (40) mit mehreren in Schwingungsrichtung (25) des Piezoaktors (40) wirkenden Piezoelementen (41 bis 44) ausgebildet ist, deren Schwingungsamplituden sich in der Schwingungsrichtung (25) des Piezoaktors (40) einander addieren.

3. Schallwandler nach einem der Ansprüche 1 oder 2,
**dadurch gekennzeichnet,**
**dass** das wenigstens eine Hebelelement (16a; 17a) zusammen mit der Membran (11) ein einstückiges Bauteil ausbilden.

4. Schallwandler nach einem der Ansprüche 1 bis 3,
**dadurch gekennzeichnet,**
**dass** der Schallwandler ferner Mittel (21) zur Dämpfung und/oder Entkopplung von Schwingungen in einer senkrecht zur Schwingungsrichtung (13) der Membran (11) angeordneten Richtung umfasst.

5. Schallwandler nach einem der Ansprüche 1 bis 4,
**dadurch gekennzeichnet,**
**dass** die Membran (11) aus einem Metall, vorzugsweise aus Aluminium, einer Keramik oder einem Verbundwerkstoff ausgebildet ist.

## Claims

1. Sound transducer (10a), comprising a diaphragm (11) and at least one piezo actuator (20a; 40) with two end faces (23a, 24a) lying opposite one another and arranged in the direction of oscillation (25) of the piezo actuator (20a; 40), which is arranged in operative connection with the diaphragm (11), wherein the direction of oscillation (25) of the piezo actuator (20a; 40) is arranged at least substantially perpendicular to the direction of oscillation (13) of the diaphragm (11), wherein the sound transducer also has two lever elements (16a, 17a) with abutting edges (31, 32), wherein the lever elements are arranged between the diaphragm (11) and the piezo actuator (20a; 40), connect the diaphragm (11) to the piezo actuator (20a; 40) and are designed to convert oscillations of the piezo actuator (20a; 40) into oscillations of the diaphragm (11) and vice versa, and wherein a clamping connection is formed between in each case one of the two lever elements (16a; 17a) and the piezo actuator (20a; 40), wherein the respective clamping connection is formed in the region between in each case one of the two end faces (23a, 24a) of the piezo actuator (20a; 40) arranged in the direction of oscillation (25) of the piezo actuator (20a; 40) and the respective lever element (16a; 17a), and in that, by means of the two lever elements (16a; 17a), the piezo actuator (20a; 40) is arranged under an axial pre-tensioning force (F) extending in the direction of oscillation (25) of the piezo actuator (20a; 40),
**characterized in that**
in the region of the two end faces (23a, 24a), the piezo actuator (20a; 40) is provided in each case with a concavely formed contact surface (27, 28), wherein the two contact surfaces (27, 28) extend symmetrically in relation to a central plane (29) of the piezo actuator (20a; 40), in which a linear contact takes place between the abutting edges (31, 32) of the lever elements (16a; 17a) on the piezo actuator (20a; 40).

2. Sound transducer according to Claim 1,
**characterized**
**in that** the piezo actuator (40) is formed as a stacked piezo actuator (40) with multiple piezo elements (41 to 44), which act in the direction of oscillation (25) of the piezo actuator (40) and the oscillation amplitudes of which are added together in the direction of oscillation (25) of the piezo actuator (40) .

3. Sound transducer according to either of Claims 1 and 2,
**characterized**
**in that** the at least one lever element (16a; 17a) forms a one-piece component with the diaphragm (11).

4. Sound transducer according to one of Claims 1 to 3,
**characterized**
**in that** the sound transducer also comprises means (21) for damping and/or decoupling oscillations in a direction arranged perpendicular to the direction of oscillation (13) of the diaphragm (11).

5. Sound transducer according to one of Claims 1 to 4,
**characterized in that** the diaphragm (11) is formed from a metal, preferably from aluminium, a ceramic or a composite material.

## Revendications

1. Transducteur acoustique (10a), comprenant une membrane (11) et au moins un actionneur piézoélectrique (20a; 40) avec deux côtés frontaux (23a, 24a) disposés en opposition l'un à l'autre dans la direction de vibration (25) de l'actionneur piézoélectrique (20a; 40), qui est disposé en liaison active avec la membrane (11), dans lequel la direction de vibration (25) de l'actionneur piézoélectrique (20a; 40) est disposée au moins essentiellement perpendiculairement à la direction de vibration (13) de la membrane (11), dans lequel le transducteur acoustique comprend en outre deux éléments de levier (16a, 17a) avec des arêtes d'appui (31, 32), dans lequel les éléments de levier sont disposés entre la membrane (11) et l'actionneur piézoélectrique (20a; 40), relient la membrane (11) à l'actionneur piézoélectrique (20a; 40) et sont conçus pour convertir des vibrations de l'actionneur piézoélectrique (20a; 40) en vibrations de la membrane (11) et inversement, et dans lequel un assemblage par serrage est réalisé respectivement entre un des deux éléments de levier (16a; 17a) et l'actionneur piézoélectrique (20a; 40), dans lequel l'assemblage par serrage respectif est réalisé respectivement entre un des deux côtés frontaux (23a, 24a) de l'actionneur piézoélectrique (20a; 40) disposés dans la direction de vibration (25) de l'actionneur piézoélectrique (20a; 40) et l'élément de levier respectif (16a; 17a), et en ce que l'actionneur piézoélectrique (20a; 40) est disposé par les deux éléments de levier (16a; 17a) sous une force de précontrainte axiale (F) s'étendant dans la direction de vibration (25) de l'actionneur piézoélectrique (20a; 40), **caractérisé en ce que** l'actionneur piézoélectrique (20a; 40) est doté dans la région des deux côtés frontaux (23a, 24a) d'une face de contact de forme concave (27, 28), dans lequel les deux faces de contact (27, 28) s'étendent de façon symétrique par rapport à un plan médian (29) de l'actionneur piézoélectrique (20a; 40), dans lequel il se produit un contact linéique entre les arêtes d'appui (31, 32) des éléments de levier (16a; 17a) sur l'actionneur piézoélectrique (20a; 40).

2. Transducteur acoustique selon la revendication 1, **caractérisé en ce que** l'actionneur piézoélectrique (40) est réalisé sous la forme d'un actionneur piézoélectrique empilé (40) avec plusieurs éléments piézoélectriques (41 à 44) agissant dans la direction de vibration (25) de l'actionneur piézoélectrique (40), dont les amplitudes de vibration s'additionnent mutuellement dans la direction de vibration (25) de l'actionneur piézoélectrique (40).

3. Transducteur acoustique selon une des revendications 1 ou 2, **caractérisé en ce que** ledit au moins un élément de levier (16a; 17a) forme avec la membrane (11) un composant en une seule pièce.

4. Transducteur acoustique selon l'une quelconque des revendications 1 à 3, **caractérisé en ce que** le transducteur acoustique comprend en outre des moyens (21) pour l'amortissement et/ou le découplage de vibrations dans une direction disposée perpendiculairement à la direction de vibration (13) de la membrane (11).

5. Transducteur acoustique selon l'une quelconque des revendications 1 à 4, **caractérisé en ce que** la membrane (11) est réalisée en un métal, de préférence en aluminium, une céramique ou un matériau composite.
